# EUROPÄISCHE PATENTSCHRIFT

(11) **EP 2 053 740 B1**
(45) Veröffentlichungstag und Bekanntmachung des Hinweises auf die Patenterteilung: **25.12.2019**
(21) Anmeldenummer: 08105650.9
(22) Anmeldetag: 24.10.2008
(51) Int. Cl.: H03K 5/19, H03K 5/26

(54) **Verfahren und Vorrichtung zum Betreiben einer Schaltungsanordnung**
Method and device for operating a circuit arrangement
Procédé et dispositif destinés à l'utilisation d'un circuit

(30) Priorität: 25.10.2007 DE 102007051173
(43) Veröffentlichungstag der Anmeldung: 29.04.2009
(73) Patentinhaber: Continental Automotive GmbH, 30165 Hannover (DE)
(72) Erfinder: Hannappel, Joachim, 65620, Waldbrunn (DE); Heyer, Christian, 68519, Viernheim (DE)
(74) Vertreter: Thiel, Linda

(56) Entgegenhaltungen:
- EP-A1- 1 333 579
- DE-A1-102004 053 321
- JP-A- H04 306 930
- US-A1- 2004 205 370
- SKINNER J: "Digital frequency window", ELECTRONICS AND TELEVISION AND SHORTWAVE WORLD, HULTON PRESS LTD. LONDON, GB, Bd. 60, Nr. 739, 1. Juli 1988 (1988-07-01) , Seite 27, XP002147205,

## Beschreibung

Die Erfindung betrifft ein Verfahren und eine Vorrichtung zum Betreiben einer Schaltungsanordnung mit einem Taktsignalgeber und einem Referenztaktsignalgeber, wobei die Schaltungsanordnung mittels des Taktsignalgebers getaktet wird und dazu ausgebildet ist, abhängig von einem vorgegebenen Sensorsignal Zähler entweder zu inkrementieren oder zu dekrementieren.

Taktsignalgeber sind beispielsweise als Oszillatoren oder Schwingquarze ausgebildet und geben ein Taktsignal einer vorgegebenen Frequenz vor. Taktsignalgeber finden Einsatz in sämtlichen Bereichen der Elektronik, insbesondere der Digitaltechnik, zu Datenverarbeitungs- und Synchronisationszwecken. Insbesondere bei der Taktung von Prozessoren oder Applikationsspezifischen Bauelementen, geben diese Taktsignalgeber die Verarbeitungsgeschwindigkeit vor. In vielen Anwendungen wird neben der Verwendung des Taktsignalgebers dessen Betrieb und die Frequenz des Taktsignals überwacht.

In Skinner, J.: "Digital frequency window", Electronics and Television and shortwave world, Hulton Press LTD. London, GB, Bd. 60, Nr. 739, 1. Juli 2988 (1988-07-01), Seite 27, XP002147205, ist ein digitales Frequenzfenster offenbart.

EP1333579A1 zeigt eine Einrichtung zur Erkennung eines Taktsignalausfalls mit einem Zähler. Bei Überschreiten oder Unterschreiten eines Referenzwertes wird ein Fehler signalisiert.

JPH04306930A zeigt eine Einrichtung zur schnellen und sicheren Erkennung von Taktunterbrechungen und Taktschwankungen.

US 2004/205370 zeigt ein Verfahren und eine Vorrichtung zum Bereitstellen von Taktsignalen für mehrere Frequenzdomänen, wobei einzelne Eingangstakte mit variabler Frequenz gewählt werden. Als Reaktion auf Steuersignale, die auf einer bestimmten Bustaktfrequenz basieren, werden unabhängige Taktsignale mit vorbestimmten Taktfrequenzzielen erzeugt.

DE102004053321A1 zeigt eine in einem Fahrzeug montierte Elektroniksteuereinrichtung, wobei ein Entladen einer Batterie mittels einer Timer-Startfunktion unterdrückt wird.

Die Aufgabe, die der Erfindung zugrunde liegt, ist es, ein Verfahren und eine Vorrichtung zum Betreiben einer Schaltungsanordnung zu schaffen, das bzw. die zuverlässig ist.

Die Aufgabe wird gelöst durch die Merkmale der unabhängigen Patentansprüche. Vorteilhafte Ausgestaltungen der Erfindung sind in den Unteransprüchen gekennzeichnet.

Die Erfindung zeichnet sich aus durch ein Verfahren und eine korrespondierende Vorrichtung zum Betreiben einer Schaltungsanordnung mit einem Taktsignalgeber und mit einem Referenztaktsignalgeber, wobei die Schaltungsanordnung mittels des Taktsignalgebers getaktet wird und dazu ausgebildet ist, abhängig von einem vorgegebenen Sensorsignal mindestens einen Zählerstand eines Zählersignals von einem Zähler entweder zu inkrementieren oder zu dekrementieren. Nach einem Einschalten des Referenztaktsignalgebers wird ein von dem eingeschalteten Taktsignalgeber vorgegebenes Taktsignal mit einer ersten Frequenz derart überwacht, dass ein Signalprozessor ausgebildet ist, nach dessen Einschalten die erste Frequenz des Taktsignalgebers derart zu erfassen, dass das Verhältnis zwischen der ersten Frequenz des Taktsignalgebers und der zweiten Frequenz des Referenzsignalgebers ermittelt wird und abhängig von einem durch den Signalprozessor ermittelten Verhältnis zwischen der ersten Frequenz und einer vorgegebenen zweiten Frequenz eines Referenztaktsignals des Referenztaktsignalgebers ein Fehler signalisiert wird und zwar derart, dass bei einem Verhältnis außerhalb eines vorgegebenen Verhältnisbereiches der mindestens eine Zählerstand des Zählersignals als ungültig erkannt und signalisiert wird, wobei eine periodische Überwachung der ersten Frequenz bei eingeschaltetem Signalprozessor durchgeführt wird und auch Zählerstände von vor der Überwachung als ungültig erkannt und signalisiert werden. Ein vorgegebenes Taktsignal erzeugt typischerweise nach einem Auftreten eines Fehlers bei dem Taktsignalgeber im folgenden Betrieb ein fehlerbehaftetes Taktsignal. Nach dem Einschalten des Referenztaktsignalgebers kann mittels dieses das Taktsignal zuverlässig als fehlerbehaftet erkannt werden und die aus dem fehlerbehafteten Taktsignal resultierenden Zählerstände zuverlässig als ungültig signalisiert werden. Mittels der Verhältnisbildung zwischen erster Frequenz des Taktsignals und der zweiten Frequenz des Referenztaktsignals kann besonders zuverlässig eine veränderte erste Frequenz des Taktsignals detektiert werden.

Gemäß einer vorteilhaften Ausgestaltung ist der vorgegebene Verhältnisbereich abhängig von einer vorgegebenen ersten unteren Grenzfrequenz, die für eine vorgegebene Anwendung der mit dem Taktsignal zu betreibenden Schaltungsanordnung vorgegeben wird. Basierend auf der Schaltungsanordnung sind je nach Anforderung verschiedene Anwendungen denkbar. Die jeweilige Anwendung kann eine vorgegebene Frequenz des Taktsignals erfordern, damit die jeweilige Anwendung den jeweiligen Anforderungen entsprechen kann.

Die Überwachung des Taktsignals repräsentiert somit auch eine Überwachung der jeweiligen Anwendung der Schaltungsanordnung, wenn der erlaubte Verhältnisbereich abhängig von einer unteren Grenzfrequenz ist, die von der jeweiligen Anwendung gefordert wird.

Gemäß einer weiteren vorteilhaften Ausgestaltung ist der vorgegebene Verhältnisbereich abhängig von einer vorgegebenen oberen Grenzfrequenz, die zum fehlerfreien Betreiben der mit dem Taktsignal zu betreibenden Schaltungsanordnung vorgegeben wird. Ein fehlerfreier Betrieb der Schaltungsanordnung erfordert typischerweise ein Taktsignal mit einer Frequenz unterhalb der oberen Grenzfrequenz, die beispielsweise abhängig von Gatterlaufzeiten der Schaltungsanordnung vorgegeben wird.

Gemäß einer weiteren vorteilhaften Ausgestaltung wird mittels des Signalprozessors die Frequenz des Taktsignalgebers überwacht. Der Signalprozessor wird typischerweise mittels des Referenztaktsignalgebers getaktet und ist somit besonders geeignet, das Taktsignal des Taktsignalgebers zu überwachen. Ausführungsbeispiele der Erfindung sind im Folgenden anhand der schematischen Zeichnungen näher erläutert. Es zeigen:

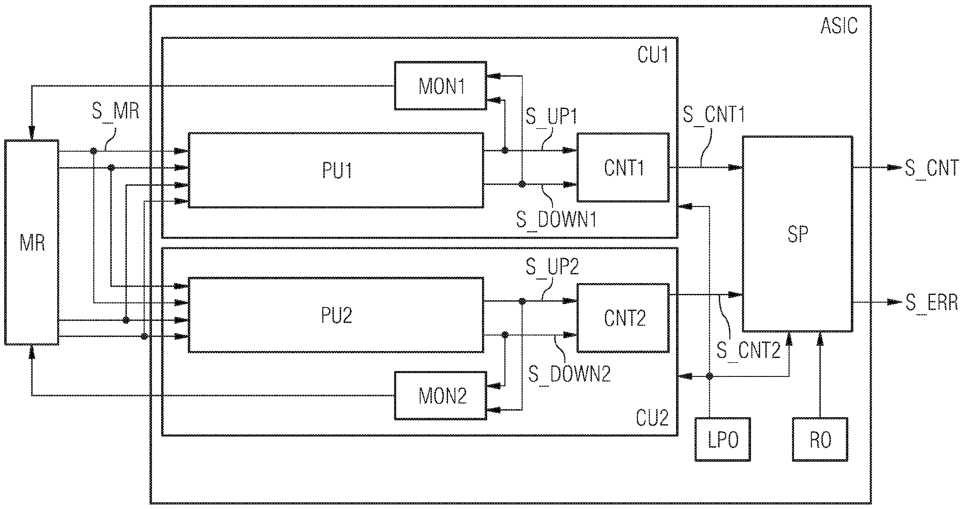

Figur 1 eine schematische Darstellung einer Schaltungsanordnung.

Elemente gleicher Konstruktion oder Funktion sind figurenübergreifend mit den gleichen Bezugszeichen gekennzeichnet.

In Figur 1 ist eine Schaltungsanordnung ASIC dargestellt, die bevorzugt als applikationsspezifisches integriertes Bauelement ausgebildet ist und beispielsweise für die Erfassung von Lenkwinkeländerungen eines Lenkrades und/oder von lenkbaren Rädern eines Kraftfahrzeugs eingesetzt werden kann. Die Schaltungsanordnung ASIC kann auch als Auswerteeinheit bezeichnet werden. Die Schaltungsanordnung ASIC umfasst eine erste Zähleinheit CU1 und eine zweite Zähleinheit CU2, denen eingangsseitig ein Sensorsignal S_MR eines Sensors MR zugeordnet ist. Der Sensor MR ist beispielsweise als magnetoresistiver Messsensor zur Erfassung einer Position eines Rotors eines elektrischen Lenkmotors ausgebildet. Moderne lenkunterstützende Lenksysteme in Kraftfahrzeugen umfassen typischerweise elektrische Lenkmotoren zur Unterstützung einer Lenkkraft eines Fahrers.

Die erste Zähleinheit CU1 umfasst einen ersten Zähler CNT1 und eine erste Verarbeitungseinheit PU1. Der ersten Verarbeitungseinheit PU1 ist eingangsseitig das Sensorsignal S_MR zugeordnet, das mittels der ersten Verarbeitungseinheit PU1 ausgewertet wird. Abhängig von der Auswertung des Sensorsignals S_MR wird ausgangsseitig entweder ein erstes Inkrementsignal S_UP1 oder ein erstes Dekrementsignal S_DOWN1 erzeugt, das dem ersten Zähler CNT1 zugeführt wird. Der erste Zähler CNT1 ist als Aufwärtszähler und Abwärtszähler ausgebildet und inkrementiert seinen aktuellen Zählerstand abhängig von dem ersten Inkrementsignal S_UP1 und dekrementiert seinen aktuellen Zählerstand abhängig von dem ersten Dekrementsignal S_DOWN1. Ausgangsseitig erzeugt der erste Zähler CNT1 ein erstes Zählersignal S_CNT1, das den aktuellen Zählerstand des ersten Zählers CNT1 umfasst.

Wird beispielsweise mittels des Sensors MR eine Umdrehung des Rotors des elektrischen Lenkmotors in einer vorgegebenen Drehrichtung erfasst, wird das dazu entsprechende zur ersten Verarbeitungseinheit PU1 übermittelte Sensorsignal S MR ausgewertet und abhängig von dem Sensorsignal S_MR ausgangsseitig entweder das erste Inkrementsignal S_UP1 oder das erste Dekrementsignal S_DOWN1 erzeugt. Dabei kann beispielsweise der erste Zähler CNT1 mittels des ersten Inkrementsignals S_UP1 mittels eines positiven Pulses mit einer vorgegebenen Pulsdauer inkrementiert werden oder mittels des ersten Dekrementsignals S_DOWN1 mittels eines positiven Pulses mit einer vorgegebenen Pulsdauer dekrementiert werden. Somit ist dem aktuellen Zählerstand des ersten Zählers CNT1 eine Anzahl von erfolgten Umdrehungen des Rotors des elektrischen Lenkmotors zugeordnet. Der Sensor MR und die erste Zähleinheit CU1 sind typischerweise derart ausgebildet, dass halbe Umdrehungen des Rotors bezogen auf einen vorgegebenen Bezugspunkt erfasst werden.

Ferner umfasst die erste Zähleinheit CU1 eine erste Überwachungseinheit MON1, der eingangsseitig das erste Inkrementsignal S_UP1 und das erste Dekrementsignal S_DOWN1 zugeordnet ist. Ausgangsseitig ist die erste Überwachungseinheit MON1 dem Sensor MR zugeordnet. Mittels der ersten Überwachungseinheit MON1 können Änderung der Rotorposition des elektrischen Lenkmotors über die Zeit erfasst werden und abhängig davon der Sensor MR angesteuert werden.

In einer vorgegebenen Anwendung der Schaltungsanordnung ASIC wird der Sensor MR permanent angesteuert, wenn innerhalb einer vorgegebenen Zeitdauer eine vorgegebene Änderung des Lenkwinkels oder der Rotorposition des elektrischen Lenkmotors erfasst wird mittels der ersten Überwachungseinheit MON1. Dagegen wird der Sensor MR getaktet angesteuert wird, wenn innerhalb der vorgegebenen Zeitdauer nur eine geringe Änderung oder keine Änderung des Lenkwinkels oder der Rotorposition erfasst wird. Die vorgegebene Anwendung gibt beispielsweise eine getaktete Ansteuerung des Sensors MR mit einer vorgegebenen dritten Frequenz, so z.B. 100 Hz, vor, so dass die erforderliche Erfassung der Änderungen des Lenkwinkels oder der Rotorposition innerhalb der vorgegebenen Zeitdauer zum Übergang in die permanente Ansteuerung des Sensors MR gewährleistet ist. Wird die vorgegebene dritte Frequenz unterschritten, ist die zuverlässige Erfassung der jeweiligen Lenkwinkeländerung oder Rotorpositionsänderung nicht mehr gewährleistet.

Die zweite Zähleinheit CU2 ist analog zu der ersten Zähleinheit CU1 ausgebildet, umfassend eine zweite Verarbeitungseinheit PU2, einen zweiten Zähler CNT2 und eine zweite Überwachungseinheit MON2.

Die erste Zähleinheit CU1 und die zweite Zähleinheit CU2 und somit die erste und zweite Verarbeitungseinheit PU1 und PU2, sowie die erste und zweite Überwachungseinheit MON1 und MON2 und der erste und zweite Zähler werden mittels eines Taktsignalgebers LPO getaktet. Der Taktsignalgeber LPO ist typischerweise als Low-Power-Oszillator ausgebildet und gibt ein Taktsignal mit einer vorgegebenen ersten Frequenz vor, so z.B. 200 kHz.

Die erste Frequenz des Taktsignals ist derart vorgegeben, dass die vorgegebene dritte Frequenz, die von der ersten Frequenz abgeleitet ist, zur Ansteuerung des Sensors MR von der ersten und zweiten Überwachungseinheit MON1 und MON2 nicht unterschritten wird und somit die Erfassung der Positionsänderung des Rotors gewährleistet ist. Die dritte Frequenz korrespondiert somit zu einer unteren Grenzfrequenz der ersten Frequenz, die aufgrund der zuverlässigen Erfassung von Lenkwinkeländerungen nicht unterschritten werden darf. Des Weiteren basiert die zur Erfassung der Rotorpositionsänderung und Lenkwinkeländerung verwendete Zeitbasis der ersten und zweiten Überwachungseinheit MON1 und MON2 auf dem Taktsignal des Taktsignalgebers LPO. Die erste Frequenz des Taktsignals wird des Weiteren derart vorgegeben, dass die in der ersten und zweiten Zähleinheit CU1 und CU2 enthaltenen Komponenten zuverlässig und fehlerfrei arbeiten. Dabei sind beispielsweise Laufzeitverzögerungen der verwendeten Logik zu berücksichtigen. Somit korrespondiert die erforderliche Frequenz zum fehlerfreien Betreiben der ersten und zweiten Zähleinheit CU1 und CU2 und deren Komponenten zu einer oberen Grenzfrequenz der ersten Frequenz.

Des Weiteren umfasst die Schaltungsanordnung ASIC einen Signalprozessor SP, der beispielsweise als Digitaler Signalprozessor ausgebildet ist. Dem Signalprozessor SP ist eingangsseitig das erste und zweite Zählersignal S_CNT1 und S_CNT2 zugeordnet. Der Signalprozessor SP ist dazu ausgebildet, die Zählerstände des ersten und zweiten Zählers CNT1 und CNT2, die mittels des ersten und zweiten Zählersignals S_CNT1 und S_CNT2 übermittelt werden, auszuwählen und mittels eines Zählerstandssignals S_CNT den ausgewählten Zählerstand einem mit der Schaltungsanordnung ASIC gekoppelten vorgegebenen Empfänger, so z.B. einem Lenksteuergerät, zu übermitteln. Des Weiteren ist der Signalprozessor SP dazu ausgebildet, die Zählerstände des ersten und zweiten Zählers CNT1 und CNT2 miteinander zu vergleichen. Werden mittels des Signalsprozessors SP unterschiedliche Zählerstände ermittelt oder liegen die Zählerstände derart auseinander, dass ein vorgegebener Differenzwert, so z.B. ein Differenzwert von 1, überschritten wird, wird mittels dieses ein Fehlerstatussignal S_ERR erzeugt, dass auch dem Empfänger übermittelt wird. Mittels des Fehlerstatussignals S_ERR kann dem Empfänger signalisiert werden, dass das parallel übermittelte Zählerstandssignal S_CNT ungültig ist und nicht verwendbar ist.

Der Signalprozessor SP wird durch einen Referenztaktsignalgeber RO getaktet, der typischerweise als Oszillator umfassend eine PLL und einen Schwingquarz ausgebildet ist und ein Referenztaktsignal mit einer zweiten Frequenz vorgibt, die z.B. 8 MHz betragen kann.

Ein fehlerfreies Zählen der Umdrehungen des Rotors des elektrischen Lenkmotors ist abhängig von dem Taktsignalgeber LPO, das die zum Zählen verwendeten Komponenten der ersten und zweiten Zähleinheit CU1 und CU2 taktet. Ein fehlerbehafteter Taktsignalgeber LPO kann somit zu Zählerständen des ersten und zweiten Zählers CNT1 und CNT2 führen, die nicht den tatsächlichen Umdrehungen des Rotors des elektrischen Lenkmotors entsprechen. Die Zählerstände sind somit ungültig und müssen somit auch als ungültig erkannt und signalisiert werden.

Dem Signalprozessor SP ist neben dem Referenztaktsignal des Referenztaktsignalgebers RO noch das Taktsignal des Taktsignalgebers LPO zugeführt. Dieses kann beispielsweise einem Timer-Eingang des Signalprozessors SP zugeordnet sein. Der Signalprozessor SP ist dazu ausgebildet, nach dessen Einschalten die erste Frequenz des Taktsignalgebers LPO derart zu erfassen, dass ein Verhältnis zwischen erster Frequenz des Taktsignalgebers LPO und der zweiten Frequenz des Referenztaktsignalgebers RO ermittelt wird. Dies kann beispielsweise derart erfolgen, dass mittels des Signalprozessors SP innerhalb einer Periodendauer des Taktsignals des Taktsignalsgebers LPO eine Anzahl voller Perioden des Referenztaktsignals gezählt wird, da die Frequenz des Referenztaktsignals höher ist als die des Taktsignals. Das ermittelte Verhältnis der ersten und zweiten Frequenz zueinander wird mit einem vorgegebenen Verhältnisbereich verglichen. Liegt das ermittelte Verhältnis innerhalb des vorgegebenen Verhältnisbereiches, sind die Zählerstände des ersten und zweiten Zählers CNT1 und CNT2 gültig.

Der vorgegebene Verhältnisbereich ist abhängig von der unteren und oberen Grenzfrequenz und gibt somit einen Frequenzbereich der ersten Frequenz des Taktsignals vor, innerhalb dessen ein zuverlässiger und fehlerfreier Betrieb der ersten und zweiten Zähleinheit CU1 und CU2 gewährleistet ist und somit Rotorpositionsänderung und Lenkwinkeländerung zuverlässig erfasst werden.

Ermittelte Verhältnisse außerhalb des vorgegebenen Verhältnisbereiches werden mittels des Signalprozessors SP zuverlässig erkannt und mittels des Fehlerstatussignals S_ERR dem Empfänger signalisiert. Der mittels des Zählerstandssignals S_CNT übermittelte Zählerstand wird somit als ungültig gekennzeichnet.

Neben der Überwachung der ersten Frequenz nach dem Einschalten des Signalprozessors SP ist gemäß der Erfindung auch eine periodische Überwachung der ersten Frequenz während des eingeschalteten Betriebs des Signalprozessors SP vorgesehen.

Grundsätzlich sind neben der Überwachung des Taktsignalgebers LPO auch weitere Überwachungen anderer zählerbeeinflussender Faktoren, wie beispielsweise eine Überwachung einer Versorgungsspannung denkbar. In diesem Zusammenhang sei darauf hingewiesen, dass zu einer Überwachung der Versorgungsspannung der Schaltungsanordnung ASIC, diese derart ausgebildet sein sollte, dass ein Unterschreiten einer vorgegebenen Versorgungsspannungsgrenze zuverlässig erkannt und signalisiert wird. Das kann beispielsweise abhängig davon erfolgen, dass der Spannungswert der vorgegebenen Versorgungsspannungsgrenze größer ist als ein Spannungswert, der zum zuverlässigen Betreiben der ersten und zweiten Zähleinheit CU1 und CU2 notwendig ist. Dadurch kann besonders zuverlässig gewährleistet werden, dass bei einem Spannungswert der Versorgungsspannung unter der vorgegebenen Versorgungsspannungsgrenze, die ermittelten Zählerstände des ersten und zweiten Zählers CNT1 und CNT2 als ungültig erkannt und signalisiert werden, obwohl der notwendige Spannungspegel zum zuverlässigen Betreiben der ersten und zweiten Zähleinheit CU1 und CU2 noch nicht unterschritten ist. Ferner kann die Schaltungsanordnung ASIC neben einer Überwachungseinheit zur Überwachung der Versorgungsspannung auch eine Reset-Einheit umfassen. Diese ist beispielsweise derart ausgebildet, dass mehrere Resetsignale mittels der Reset-Einheit erzeugt werden und die Erzeugung der Resetsignale abhängig von dem aktuellen Spannungswert der Versorgungsspannung ist. Ist beispielsweise der Spannungswert der Versorgungsspannung kleiner als eine vorgegebene erste Spannungsgrenze, wird mittels der Reset-Einheit ein erstes Resetsignal erzeugt, das beispielsweise den Signalprozessor SP in einen vorgegebenen Resetzustand hält. Ist beispielsweise der Spannungswert der Versorgungsspannung kleiner als eine vorgegebene zweite Spannungsgrenze, wird mittels der Reset-Einheit ein zweites Resetsignal erzeugt, dass beispielsweise die erste und zweite Zähleinheit CU1 und CU2 und den Sensor MR in einen vorgegebenen Resetzustand hält. Der Wert der ersten Spannungsgrenze ist dabei typischerweise verschieden zum Wert der zweiten Spannungsgrenze. Die erste und zweite Spannungsgrenze kann in einem weiteren Ausführungsbeispiel derart ausgebildet sein, dass sie jeweils eine Spannungsgrenze für eine ansteigende und eine abfallende Versorgungsspannung umfassen, die typischerweise verschieden sind, so dass den jeweiligen Spannungsgrenzen eine Schalthysteresis zugeordnet ist.

## Patentansprüche

1. Verfahren zum Betreiben einer Schaltungsanordnung (ASIC) mit einem Signalprozessor (SP), einem Taktsignalgeber (LPO) und mit einem Referenztaktsignalgeber (RO),
- wobei die Schaltungsanordnung (ASIC) mittels des Taktsignalgebers (LPO) getaktet wird und dazu ausgebildet ist, abhängig von einem vorgegebenen Sensorsignal (S_MR) mindestens einen Zählerstand eines Zählersignals (S_CNT1, S_CNT2) von mindestens einem Zähler (CNT1, CNT2) entweder zu inkrementieren oder zu dekrementieren und
- bei dem Verfahren nach einem Einschalten des Referenztaktsignalgebers (RO) ein von dem eingeschalteten Taktsignalgeber (LPO) vorgegebenes Taktsignal mit einer ersten Frequenz überwacht wird, wobei für die Überwachung
- der Signalprozessor (SP) ausgebildet ist, nach dessen Einschalten die erste Frequenz des Taktsignalgebers (LPO) derart zu erfassen, dass das Verhältnis zwischen der ersten Frequenz des Taktsignalgebers (LPO) und einer vorgegebenen zweiten Frequenz eines Referenztaktsignals des Referenztaktsignalgebers (RO) ermittelt wird und
- abhängig von einem durch den Signalprozessor (SP) ermittelten Verhältnis zwischen der ersten Frequenz und
der zweiten Frequenz ein Fehler signalisiert wird und zwar derart, dass bei einem Verhältnis außerhalb eines vorgegebenen Verhältnisbereiches der mindestens eine Zählerstand des Zählersignals (S_CNT1, S_CNT2) als ungültig erkannt und signalisiert wird, wobei eine periodische Überwachung der ersten Frequenz bei eingeschaltetem Signalprozessor (SP) durchgeführt wird und auch Zählerstände von vor der Überwachung als ungültig erkannt und signalisiert werden.

2. Verfahren nach Anspruch 1, bei dem der vorgegebene Verhältnisbereich abhängig ist von einer vorgegebenen unteren Grenzfrequenz, die für eine vorgegebene Anwendung der mit dem Taktsignal zu betreibenden Schaltungsanordnung (ASIC) vorgegeben wird.

3. Verfahren nach Anspruch 1 oder 2, bei dem der vorgegebene Verhältnisbereich abhängig ist von einer vorgegebenen oberen Grenzfrequenz, die zum fehlerfreien Betreiben der mit dem Taktsignal zu betreibenden Schaltungsanordnung (ASIC) vorgegeben wird.

4. Verfahren nach einem der vorstehenden Ansprüche, bei dem mittels des Signalprozessors (SP) die Frequenz des Taktsignalgebers (LPO) überwacht wird.

5. Vorrichtung zum Betreiben einer Schaltungsanordnung (ASIC) mit Signalprozessor (SP), einem Taktsignalgeber (LPO) und mit einem Referenztaktsignalgeber (RO),
- wobei die Schaltungsanordnung (ASIC) mittels des Taktsignalgebers (LPO) getaktet wird und dazu ausgebildet ist, abhängig von einem vorgegebenen Sensorsignal (S MR) mindestens einen Zählerstand eines Zählersignals (S_CNT1, S_CNT2) von mindestens einem Zähler (CNT1, CNT2) entweder zu inkrementieren oder zu dekrementieren und
- die Vorrichtung dazu ausgebildet ist, nach einem Einschalten des Referenztaktsignalgebers (RO) ein von dem eingeschalteten Taktsignalgeber (LPO) vorgegebenes Taktsignal mit einer ersten Frequenz zu überwachen, wobei für die Überwachung
- der Signalprozessor (SP) ausgebildet ist, nach dessen Einschalten die erste Frequenz des Taktsignalgebers (LPO) derart zu erfassen, dass das Verhältnis zwischen der ersten Frequenz des Taktsignalgebers (LPO) und einer vorgegebenen zweiten Frequenz eines Referenztaktsignals des Referenztaktsignalgebers (RO) ermittelt wird und
- abhängig von einem durch den Signalprozessor (SP) ermittelten Verhältnis der ersten Frequenz zu der zweiten Frequenz ein Fehler angezeigt wird und zwar derart, dass bei einem Verhältnis außerhalb eines vorgegebenen Verhältnisbereiches der mindestens eine Zählerstand des Zählersignals (S_CNT1, S_CNT2) als ungültig erkannt und signalisiert wird, wobei eine periodische Überwachung der ersten Frequenz bei eingeschaltetem Signalprozessor (SP) durchgeführt wird und auch Zählerstände von vor der Überwachung als ungültig erkannt und signalisiert werden.

## Claims

1. Method for operating a circuit arrangement (ASIC) having a signal processor (SP), a clock signal generator (LPO) and having a reference clock signal generator (RO),
- wherein the circuit arrangement (ASIC) is clocked by means of the clock signal generator (LPO) and is designed to take a prescribed sensor signal (S_MR) as a basis for either incrementing or decrementing at least one count of a counter signal (S_CNT1, S_CNT2) for at least one counter (CNT1, CNT2) and
- the method involves a clock signal, which is prescribed by the switched-on clock signal generator (LPO), at a first frequency being monitored after the reference clock signal generator (RO) is switched on, wherein, for the monitoring,
- the signal processor (SP) is designed so as, after it is switched on, to detect the first frequency of the clock signal generator (LPO) such that the ratio between the first frequency of the clock signal generator (LPO) and a prescribed second frequency of a reference clock signal of the reference clock signal generator (RO) is ascertained and
- a ratio that the signal processor (SP) ascertains between the first frequency and the second frequency is taken as a basis for signalling an error, specifically such that a ratio outside a prescribed ratio range results in the at least one count of the counter signal (S_CNT1, S_CNT2) being identified and signalled as invalid, wherein periodic monitoring of the first frequency is performed while the signal processor (SP) is switched on, and counts from before the monitoring are also identified and signalled as invalid.

2. Method according to Claim 1, in which the prescribed ratio range is dependent on a prescribed lower cut-off frequency prescribed for a prescribed application of the circuit arrangement (ASIC) to be operated with the clock signal.

3. Method according to Claim 1 or 2, in which the prescribed ratio range is dependent on a prescribed upper cut-off frequency prescribed for error-free operation of the circuit arrangement (ASIC) to be operated with the clock signal.

4. Method according to one of the preceding claims, in which the signal processor (SP) is used to monitor the frequency of the clock signal generator (LPO).

5. Apparatus for operating a circuit arrangement (ASIC) having a signal processor (SP), a clock signal generator (LPO) and having a reference clock signal generator (RO),
- wherein the circuit arrangement (ASIC) is clocked by means of the clock signal generator (LPO) and is designed to take a prescribed sensor signal (S_MR) as a basis for either incrementing or decrementing at least one count of a counter signal (S_CNT1, S_CNT2) for at least one counter (CNT1, CNT2) and
- the apparatus is designed to monitor a clock signal, which is prescribed by the switched-on clock signal generator (LPO), at a first frequency after the reference clock signal generator (RO) is switched on,
wherein, for the monitoring,
- the signal processor (SP) is designed so as, after it is switched on, to detect the first frequency of the clock signal generator (LPO) such that the ratio between the first frequency of the clock signal generator (LPO) and a prescribed second frequency of a reference clock signal of the reference clock signal generator (RO) is ascertained and
- a ratio that the signal processor (SP) ascertains for the first frequency to the second frequency is taken as a basis for indicating an error, specifically such that a ratio outside a prescribed ratio range results in the at least one count of the counter signal (S_CNT1, S_CNT2) being identified and signalled as invalid, wherein periodic monitoring of the first frequency is performed while the signal processor (SP) is switched on, and counts from before the monitoring are also identified and signalled as invalid.

## Revendications

1. Procédé pour faire fonctionner un circuit (ASIC) comprenant un processeur de signal (SP), un générateur de signal d'horloge (LPO) et un générateur de signal d'horloge de référence (RO),
- dans lequel le circuit (ASIC) est cadencé au moyen du générateur de signal d'horloge (LPO) et est conçu soit pour incrémenter soit pour décrémenter au moins une valeur de compteur d'un signal de compteur (S_CNT1, S_CNT2) d'au moins un compteur (CNT1, CNT2) en fonction d'un signal de capteur prédéterminé (S_MR), et
- procédé dans lequel, après que le générateur de signal d'horloge de référence (RO) a été activé, un signal d'horloge prédéterminé par le générateur de signal d'horloge (LPO) activé est surveillé à une première fréquence, dans lequel, pour la surveillance
- le processeur de signal (SP) est conçu pour détecter la première fréquence du générateur de signal d'horloge (LPO) après son activation de manière à déterminer la relation entre la première fréquence du générateur de signal d'horloge (LPO) et une seconde fréquence prédéterminée d'un signal d'horloge de référence du générateur de signal d'horloge de référence (RO), et
- en fonction d'un rapport déterminé par le processeur de signal (SP) entre la première fréquence et la seconde fréquence, une erreur est signalée de manière à ce que, lorsque le rapport se situe en-dehors d'une plage prédéterminée, ladite au moins une valeur de compteur du signal de compteur (S_CNT1, S_CNT2) soit reconnue comme étant invalide et soit signalée, dans lequel une surveillance périodique de la première fréquence est effectuée lorsque le processeur de signal (SP) est activé et des valeurs de compteur antérieures à la surveillance sont également reconnues comme étant invalides et sont signalées.

2. Procédé selon la revendication 1, dans lequel la plage de rapports prédéterminée dépend d'une fréquence limite inférieure prédéterminée, qui est prédéterminée pour une application prédéterminée du circuit (ASIC) devant fonctionner avec le signal d'horloge.

3. Procédé selon la revendication 1 ou 2, dans lequel la plage de rapports prédéterminée dépend d'une fréquence limite supérieure prédéterminée, qui est prédéterminée pour un fonctionnement sans erreur du circuit (ASIC) devant fonctionner avec le signal d'horloge.

4. Procédé selon l'une des revendications précédentes, dans lequel la fréquence du générateur de signal d'horloge (LPO) est surveillée au moyen d'un processeur de signal (SP).

5. Dispositif pour faire fonctionner un circuit (ASIC) comprenant un processeur de signal (SP), un générateur de signal d'horloge (LPO) et un générateur de signal d'horloge de référence (RO),
- dans lequel le circuit (ASIC) est cadencé au moyen du générateur de signal d'horloge (LPO) et est conçu soit pour incrémenter soit pour décrémenter au moins une valeur de compteur du signal de compteur (S_CNT1, S_CNT2) d'au moins un compteur (CNT1, CNT2) en fonction d'un signal de capteur prédéterminé (S_MR), et
- le dispositif est conçu, après que le générateur de signal d'horloge de référence (RO) a été activé, pour surveiller un signal d'horloge prédéterminé par le générateur de signal d'horloge activé (LPO) et présentant une première fréquence, dans lequel, pour la surveillance
- le processeur de signal (SP) est conçu pour détecter la première fréquence du générateur de signal d'horloge (LPO) après son activation de manière à déterminer la relation entre la première fréquence du générateur de signal d'horloge (LPO) et une seconde fréquence prédéterminée d'un signal d'horloge de référence du générateur de signal d'horloge de référence (RO), et
- en fonction d'un rapport déterminé par le processeur de signal (SP) entre la première fréquence et la seconde fréquence, une erreur est signalée de manière à ce que, lorsque le rapport se situe en-dehors d'une plage prédéterminée, ladite au moins une valeur de compteur du signal de compteur (S_CNT1, SCNT2) soit reconnue comme étant invalide et soit signalée, dans lequel une surveillance périodique de la première fréquence est effectuée lorsque le processeur de signal (SP) est activé et des valeurs de compteur antérieures à la surveillance sont également reconnues comme étant invalides et sont signalées.
